(19) Europäisches Patentamt / European Patent Office / Office européen des brevets

(11) **EP 3 386 747 B1**

(12) **FASCICULE DE BREVET EUROPEEN**

(45) Date de publication et mention de la délivrance du brevet:
**15.06.2022 Bulletin 2022/24**

(21) Numéro de dépôt: **16819621.0**

(22) Date de dépôt: **08.12.2016**

(51) Classification Internationale des Brevets (IPC):
**B32B 17/06** (2006.01)   **B23K 13/01** (2006.01)
**B23K 35/26** (2006.01)   **B23K 101/38** (2006.01)
**C03C 17/06** (2006.01)   **C03C 17/36** (2006.01)
**C22C 13/00** (2006.01)

(52) Classification Coopérative des Brevets (CPC):
**B23K 13/01; B23K 35/262; C03C 17/06;**
**C03C 17/36; C22C 13/00;** B23K 2101/38

(86) Numéro de dépôt international:
**PCT/FR2016/053274**

(87) Numéro de publication internationale:
**WO 2017/098164 (15.06.2017 Gazette 2017/24)**

(54) **VITRAGE MUNI D'UN DISPOSITIF CONDUCTEUR ELECTRIQUE ET POSSEDANT UNE RESISTANCE AMELIOREE AUX TESTS CYCLIQUES DE TEMPERATURE**

VERGLASUNG MIT ELEKTRISCHER LEITUNGSEINRICHTUNG UND MIT VERBESSERTEM WIDERSTAND GEGEN ZYKLISCHE WÄRMEBEHANDLUNGSTESTS

GLAZING WITH ELECTRICAL CONDUCTION DEVICE AND HAVING IMPROVED RESISTANCE TO HEAT CYCLING TESTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2015 FR 1562116**

(43) Date de publication de la demande:
**17.10.2018 Bulletin 2018/42**

(73) Titulaire: **SAINT-GOBAIN GLASS FRANCE**
**92400 Courbevoie (FR)**

(72) Inventeurs:
• **WERNER, Katja**
**52151 Simmerath (DE)**
• **REUL, Bernhard**
**52134 Herzogenrath (DE)**
• **SCHMALBUCH, Klaus**
**F-84220Goult (FR)**
• **DASSONVILLE, Camille**
**60200 Compiegne (FR)**
• **BRIQUET, Clément**
**60157 Elincourt Sainte Marguerite (FR)**
• **JAMART, Juliette**
**60200 Compiegne (FR)**

(74) Mandataire: **Saint-Gobain Recherche**
**Département Propriété Industrielle**
**39 Quai Lucien Lefranc**
**93300 Aubervilliers (FR)**

(56) Documents cités:
**US-A1- 2004 104 262    US-A1- 2015 162 677**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

La présente invention porte sur un vitrage comprenant un élément de connexion électrique, son procédé de fabrication et son utilisation dans le domaine des vitrages pour véhicules.

L'invention porte plus particulièrement sur un vitrage pour automobiles équipé d'une fonction électrique comme par exemple des vitrages chauffants ou dégivrants ou encore équipé d'antennes. Les fils chauffants, antennes ou autres capteurs présents dans les vitrages automobiles sont des pistes électroconductrices faites à partir d'une pâte conductrice, comme par exemple une pâte à l'argent sérigraphiée sur un substrat en verre, et sont connectés à un système d'alimentation électrique par l'intermédiaire de connecteurs soudés à la pâte conductrice. En raison des différences des coefficients d'expansion thermique des matériaux utilisés dans ces systèmes, des contraintes ou tensions mécaniques apparaissent pendant la fabrication et la manipulation des vitrages, induisant une fragilisation et l'apparition de fissures dans le vitrage, notamment au niveau de l'emplacement de ces connecteurs. Les alliages de soudure utilisés jusqu'à présent étaient généralement à base de plomb, donc à base d'un métal à ductilité élevée. Ceci permettait de passer les tests de résistance imposés par les constructeurs, sans qu'apparaissent des fissures telles qu'elles rendraient le vitrage non conforme pour l'utilisation souhaitée. Une directive européenne interdit actuellement d'utiliser ce type d'alliage à base de plomb et de nombreux travaux ont été réalisés en vue de trouver d'autres alliages de soudure susceptibles de remplacer les alliages à base de plomb. Un bon compromis est obtenu avec des alliages qui comprennent de l'étain, de l'argent et du cuivre. Ces alliages possèdent à la fois les bonnes propriétés permettant leur soudure et la robustesse nécessaire pour passer les tests actuels imposés par les fabricants automobiles. En parallèle de cette problématique liée à la suppression du plomb dans les alliages de soudure, une sévérisation des tests de vieillissement réalisés sur les connecteurs a été opérée, en particulier sur les conditions des tests de cycle en température. Ces tests sont connus sous la terminologie anglophone de "Temperature Cycling Test" ou TCT. L'objectif de ces tests est de déterminer si le vitrage peut résister à des montées et descentes en température successives et rapides, sans être fragilisé. Ces tests ont été mis au point pour accélérer les effets qui seraient provoqués par les différences de comportement thermique des différents composants du système. Le nouveau test impose des variations de température entre -40°C et +105°C, donc sur une plage de variation plus importante que les tests précédents qui se limitaient à 90°C. Le nombre de cycle a également été modifié puisqu'il est passé de 10 cycles à un minimum de 60 cycles. Les nouvelles conditions du TCT imposent également que ces variations de température soient effectuées sous une tension de 14 V pendant les phases de montée en température, ce qui entraîne des échauffements supplémentaires et correspond à des températures locales qui peuvent aller approximativement jusqu'à 120°C. Malgré les optimisations faites sur la forme du connecteur et le choix du matériau, les systèmes connus et utilisés actuellement ne sont pas assez résistants et des craquelures ou fissures peuvent apparaitre après les tests sévérisés. En effet, la rigidité plus importante des alliages à base d'étain, d'argent et de cuivre, comparativement aux alliages à base de plomb, entraîne un transfert plus important des contraintes jusqu'au substrat. Les propriétés physiques de cet alliage combinées aux tests TCT plus sévères conduisent à une plus grande génération de défauts ou fissures dans les vitrages. Les températures plus élevées atteintes entrainent également une expansion thermique plus importante du connecteur et de l'alliage de soudure, ce qui conduit à des sollicitations plus importantes de l'élément de connexion électrique dans son ensemble. Les vitrages munis de ce type de connecteur et d'alliage ne passent donc pas les critères imposés par ces tests et deviennent ainsi non conformes aux critères imposés par les constructeurs.

US2015162677A1 divulgue un vitrage comprenant un substrat en verre, comprenant un élément électriquement conducteur comprenant un connecteur fait d'acier contenant du chrome, ledit connecteur étant soudé à une piste électriquement conductrice par un composé de soudure à base d'étain, d'argent et de cuivre, ledit piste étant à base d'argent.

La présente invention porte sur un vitrage constitué d'un substrat comprenant un système de connexion électrique déposé sur le substrat, composé d'au moins un connecteur électrique, une pâte conductrice métallique et un alliage de soudure, ledit système présentant une meilleure robustesse vis-à-vis des tests de comportement en température puisqu'il permet une réduction significative du nombre de fissures susceptibles de pouvoir apparaitre dans le substrat après les tests de montée et descente en température.

Un objet de la présente invention est un vitrage constitué d'un substrat dont au moins une partie comprend un élément conducteur électrique, ledit élément conducteur comprenant un connecteur en acier contenant du chrome, soudé par un alliage de soudure à base d'étain, d'argent et de cuivre sur une piste électroconductrice, dans lequel la piste électroconductrice à base d'argent a une résistivité, mesurée à 25°C, inférieure ou égale à 3.5 $\mu\Omega$.cm et un niveau de porosité inférieur à 20% ledit niveau de porosité étant mesuré par microscopie électronique à balayage sur une coupe transversale de la partie du substrat comprenant la piste électroconductrice et ayant été préalablement polie par polissage ionique. Le vitrage selon l'invention est un vitrage résistant au test TCT imposant 60 cycles successifs au cours desquels on fait varier la température entre -40°C et +105°C, sous une tension de 14V pendant les phases de montée en température.

Les inventeurs ont montré de façon surprenante qu'en choisissant un matériau particulier pour le connecteur, un type d'alliage de soudure spécifique et une pâte conductrice à l'argent présentant à la fois un faible niveau de porosité et une faible résistance spécifique, il était possible d'obtenir un système de connexion électrique pour vitrage automobile qui résiste aux nouvelles conditions des tests TCT.

Lorsqu'on parle de cuisson de la pâte électroconductrice, on parle d'un traitement thermique sous air à une température comprise entre 550°C et 700°C pendant une durée variant de 2 à 10 minutes, permettant de fixer la pâte d'argent électroconductrice sur le substrat. Les mesures permettant de caractériser la piste électroconductrice sont réalisées après sa cuisson.

La piste électroconductrice à base d'argent est une pâte d'argent frittée comprenant un mélange de poudre d'argent et de fritte de verre. Avantageusement, la pâte d'argent comprend des particules de tailles différentes parmi lesquelles on trouve des petites particules de taille inférieure à 500nm. Préférentiellement les petites particules sont de forme sphérique dont le diamètre est inférieur à 500nm. La taille et la forme des particules d'argent sont mesurées sur des images obtenues par observation au microscope électronique à balayage de la coupe transversale du substrat revêtu de la piste électroconductrice d'argent après cuisson et polissage ionique.

Avantageusement, la granulométrie des particules d'argent présentes dans la piste électroconductrice est telle que le diamètre moyen D10 est inférieur à 1,1 $\mu$m, le diamètre D10 représentant le diamètre pour lequel 10% des particules ont un diamètre inférieur à cette valeur. Préférentiellement, le diamètre D10 est inférieur à 0.8 $\mu$m. Les mesures de granulométrie sont effectuées à l'aide d'un granulomètre laser, par exemple Mastersizer MS2000.

Le niveau de porosité de la piste électroconductrice en argent est déterminé par microanalyse de la couche de pâte d'argent déposée par sérigraphie sur au moins une partie du substrat. Des observations au microscope électronique à balayage sont effectuées sur une coupe transversale de la partie du substrat revêtu de ladite piste électroconductrice. L'image obtenue par microscopie électronique à balayage (MEB) donne accès à des zones de coloration gris clair, qui correspondent à la pâte d'argent, à des zones d'un gris plus foncé, correspondant à la fritte de verre présente dans la pâte conductrice et à des zones noires traduisant la porosité de la couche. Le niveau de porosité de la couche est calculé en déterminant le pourcentage de zones noires par traitement d'images d'une zone déterminée. L'observation est par exemple effectuée sur une longueur de 50 $\mu$m de la coupe transversale du substrat, les images étant obtenues par MEB, avec un grossissement de 5000 et une tension de 10 kV. Le niveau de porosité est donné en pourcentage et est une valeur correspondant à la moyenne des différentes valeurs des niveaux de porosité obtenues après des observations sur dix positions différentes.

Ainsi, la méthode de mesure du niveau de porosité de la piste électroconductrice utilisée dans la présente invention est la suivante :

  1) observation au microscope électronique d'une longueur d'environ 50$\mu$m de la coupe transversale polie par polissage ionique de la partie du substrat revêtu de ladite piste,
  2) détermination par traitement d'images de la quantité de zones noires observées et traduisant la porosité pour déterminer le niveau de porosité exprimé en pourcentage de zones noires par rapport à la totalité de la surface observée,
  3) répétition des étapes 1 et 2 sur au moins dix zones différentes de la coupe transversale polie pour obtenir au moins dix valeurs de niveau de porosité,
  4) calcul de la moyenne des valeurs obtenues des niveaux de porosité.

Il est essentiel pour limiter la propagation des fissures que la piste électroconductrice soit « peu poreuse », c'est à dire que son niveau de porosité soit inférieur à 20%

De façon préférentielle, la piste électroconductrice à base de pâte d'argent possède une distribution de porosité pour laquelle la plus grande longueur de 90% des pores est inférieure à 6 $\mu$m. La taille des pores est mesurée par microscopie électronique à balayage sur une coupe transversale de la partie du substrat comprenant la piste électroconductrice, après cuisson, et ayant été préalablement polie par polissage ionique.

En plus de cette condition relative au niveau de porosité de la couche, il est également nécessaire que la piste électroconductrice en argent présente une résistivité inférieure ou égale à 3.5 $\mu\Omega$.cm, cette résistivité étant mesurée à une température de 25°C. La résistivité de moins de 3.5 $\mu\Omega$.cm permet de s'assurer de la bonne compatibilité entre la pâte conductrice en argent et l'alliage de soudure en acier à base de chrome. La résistivité $\rho$, exprimée en Ohms.cm, est obtenue en mesurant la résistance électrique R en ohms d'un fil conducteur en argent en prenant en compte la longueur l en m et la section du fil S en m$^2$.

$$\rho = R \cdot \frac{s}{l}$$

La mesure de la section du fil est par exemple réalisée par une méthode de profilométrie avec ou sans contact. La mesure de résistivité est général ement effectuée sur un méandre de 1 m de longueur.

La pâte conductrice en argent utilisée pour sérigraphier les pistes électroconductrices contient de façon avantageuse entre 90 et 97% en poids d'argent, le reste étant de la fritte de verre. Cette teneur en argent correspond à la teneur après cuisson de la pâte électroconductrice. L'épaisseur de la piste électroconductrice en argent mesurée après cuisson varie entre 2 et 30 μm et préférentiellement entre 5 et 15 μm.

L'alliage utilisé pour souder le connecteur électrique à la piste électroconductrice en argent est un alliage à base d'étain, d'argent et de cuivre. Il s'agit d'un alliage considéré comme « sans plomb », répondant aux normes imposées par la directive européenne. L'alliage utilisé pour souder le connecteur sur le vitrage selon la présente invention est un alliage qui comprend de 90 à 99,5% en poids d'étain, préférentiellement de 93 à 99% en poids et encore plus préférentiellement de 95 à 98% en poids d'étain. Il comprend également, en plus de l'étain de 0,5 à 5 % en poids d'argent et jusqu'à 5% en poids de cuivre. L'alliage peut également comprendre du bismuth, de l'indium, du zinc et/ou du manganèse. De façon très préférée, l'alliage de soudure est un alliage contenant 96,5% en poids d'étain, 3% en poids d'argent et 0,5% en poids de cuivre. L'alliage de soudure est disposé sur les parties inférieures du connecteur électrique. L'épaisseur de la couche d'alliage de soudure est de préférence inférieure ou égale à 600 μm et est encore plus préférentiellement comprise entre 150 et 600 μm.

Le connecteur électrique est en acier contenant du chrome. De façon très préférée, le connecteur électrique est en acier inoxydable, c'est-à-dire en acier comprenant au moins 10,5% en poids de chrome. Ce type de connecteur présente l'avantage d'être compatible avec les alliages de soudure à base d'étain, de cuivre et d'argent. Il faut en effet que les différents matériaux possèdent des coefficients d'expansion thermique qui permettent de les utiliser conjointement, sans risquer de générer des contraintes mécaniques trop importantes qui entraineraient des zones de fragilité et la propagation de fissures. La conductivité thermique des connecteurs en acier inoxydables est d'environ 25 à 30 W/mK, ce qui est plus élevée que celle d'un connecteur qui serait fait dans un alliage à base de titane par exemple. Cette conductivité thermique plus élevée facilite le procédé de soudage grâce à un chauffage plus uniforme. Le connecteur en acier inoxydable présente l'avantage de moins se dilater qu'un connecteur à base de cuivre, par exemple. Les alliages en acier inoxydables qui conviennent particulièrement sont par exemples les aciers 1.4016, 1.4113, 1.4509 et 1.4510 selon la norme EN 10 088-3. Le connecteur a de préférence une épaisseur comprise entre 0,1 et 2 mm, plus préférentiellement entre 0.2 et 1 mm et encore plus préférentiellement entre 0,3 et 0,8 mm.

Le connecteur possède éventuellement un revêtement ou couche de mouillage à base de nickel, cuivre, zinc, étain, argent, or ou leurs alliages, sur la surface qui est contact avec l'alliage de soudure. De façon préférée, ce revêtement est à base de nickel et/ ou d'argent. L'épaisseur de ce revêtement est préférentiellement entre 0,1 μm et 0,3 μm pour du nickel et de 3 à 20 μm pour de l'argent.

Selon un mode de réalisation, le connecteur électrique possède sur sa face inférieure destinée à être placée sur le substrat au moins deux plots ou au moins un espaceur qui permettent de s'assurer que la liaison entre le connecteur et la couche conductrice en argent est correctement faite par l'intermédiaire de l'alliage de soudure. Ces plots ou espaceurs rendent le système plus robuste en aidant à contenir l'alliage et à éviter d'avoir des zones avec des quantités inhomogènes d'alliage de soudure qui pourraient provoquer des zones avec une moins bonne adhésion entre les différents composants. Ces plots ou espaceur permettent également de diminuer les contraintes mécaniques qui peuvent exister entre l'élément connecteur et le substrat. Ils ont avantageusement une forme circulaire et sont notamment décrits dans la demande de brevet US 2014/0110166. Ces plots ou espaceurs ont de préférence une largeur variant entre $0.5 \times 10^{-4}$ m et $10 \times 10^{-4}$ m et une hauteur variant entre $0.5 \times 10^{-4}$ m et $5 \times 10^{-4}$ m. La présence de ces plots ou de l'espaceur permet notamment de contrôler l'épaisseur d'alliage de soudure que l'on place sous le connecteur. Il est en effet avantageux de pouvoir maintenir une épaisseur d'alliage la plus homogène possible pour éviter tout amas qui pourrait entraîner une zone particulière de fragilisation, la contrainte étant d'autant plus importante que l'épaisseur est importante.

Le connecteur peut également être muni d'au moins une bosse de contact qui permet de faciliter sa soudure. Cette bosse de contact est située sur la zone à souder du connecteur.

Le substrat sur lequel est placé le système de connexion électrique est de préférence en verre, et plus particulièrement en verre plat, par exemple fabriqué par un procédé de flottage (ou procédé « float ») dans lequel le verre fondu est déversé sur un bain métallique en fusion. Il peut par exemple être un verre en quartz, un verre borosilicate, un verre aluminosilicate et/ou un verre sodocalcique. Le substrat peut également être de type polymérique, et peut comprendre du polyéthylène, du polypropylène, du polycarbonate, du polyméthacrylate de méthyle, du polystyrène, du polybutadiène, des polynitriles, du polyester, du polyuréthane, du polychlorure de vinyle, des polyacrylates, du polyamide, du polyéthylène téréphtalate et/ou leurs copolymères ou leurs mélanges. Le substrat est de préférence transparent. Il a une épaisseur comprise entre 0,5 mm et 25 mm, et de façon préférée entre 0,5 et 10 mm.

Le substrat peut être un verre trempé ou un verre non trempé. En utilisant un verre trempé, on renforce la couche de surface qui devient donc plus résistante, ce qui permet de mettre en évidence plus facilement les phénomènes de fragilisation engendrés par la présence du système de connexion électrique.

L'invention porte également sur un procédé de fabrication d'un vitrage constitué d'au moins un substrat possédant un système de connexion électrique, ledit procédé comprenant les étapes suivantes :

a) application d'un alliage de soudure à base d'étain, de cuivre et d'argent sur au moins une zone de contact d'un connecteur électrique en acier à base de chrome,

b) placement du connecteur électrique avec l'alliage de soudure sur une piste électroconductrice en argent déposée sur le substrat nu ou avec un revêtement; ladite piste ayant une résistivité mesurée à 25°C inférieure ou égale à 3.5 μΩ.cm et un niveau de porosité inférieur à 20%, ledit niveau de porosité étant mesuré par microscopie électronique à balayage sur une coupe transversale polie par polissage ionique d'une partie du substrat comprenant le système de connexion électrique et

c) soudure de la zone de contact du connecteur à la piste électroconductrice en argent.

Préférentiellement lors de l'étape a), une faible quantité d'alliage de soudure, sous la forme d'une plaquette ou d'une goutte aplatie est déposée sur la zone de contact du connecteur. La forme, le volume et l'épaisseur de l'alliage déposé sont prédéterminées. De préférence, l'épaisseur de la plaquette d'alliage de soudure déposée est inférieure ou égale à 0,6 mm. La forme est de préférence identique à la forme de la zone de contact, pour s'assurer que celle-ci sera en contact de la piste électroconductrice sur la totalité de sa surface.

La piste électroconductrice en argent est obtenue en déposant sur le substrat par des méthodes connues de l'homme de l'art, par exemple par sérigraphie une pâte conductrice d'argent (émail à base d'argent). Le dépôt de la couche de pâte conductrice en argent est fait indépendamment de l'étape a), dans le sens où il peut être fait avant, pendant ou après l'étape a). La couche de pâte d'argent peut être déposée directement sur le substrat, ou sur une couche elle-même déposée sur le substrat. Ainsi la couche de pâte conductrice en argent peut être déposée sur une couche d'émail noir déposée sur le substrat, essentiellement destinée à rendre invisible de l'extérieur du vitrage le système de connexion électrique.

Une fois déposée, la couche de pâte conductrice est ensuite séchée à 150°C environ puis cuite sous air à une température comprise entre 550°C et 700°C pendant une durée variant de 2 à 10 minutes (étape de frittage). L'émail à base d'argent ainsi fritté se présente sous forme solide. Les cosses de contacts ou connecteurs peuvent être soudées pour permettre l'alimentation électrique des fils conducteurs.

La soudure du connecteur sur la piste électroconductrice en argent peut être réalisée par poinçonnage, par soudage par piston, par soudage par microflamme, par soudage laser, par soudage sous air chaud, par soudage par induction, par soudage résistif et/ ou avec des ultrasons.

La présente invention porte également sur l'utilisation d'un vitrage comprenant au moins un système de connexion électrique tel que décrit ci-avant, dans des bâtiments ou des véhicules, en particulier des véhicules automobiles, des véhicules ferroviaires ou des avions.

Les vitrages sont notamment utilisés en tant que pare-brises, fenêtres latérales, lunettes arrière ou toit chauffants ou équipés d'une antenne ou de tout autre fonction électrique disposée sur ou dans le vitrage.

Les exemples ci-après illustrent l'invention de façon non limitative.

Le test de montée et descente en température ou « temperature cycling test » est un test décrit dans la norme EN ISO 16750-4-H section 5.3.1.2. Les températures et les durées des cycles sont données dans le tableau ci-dessous :

| Durée (min) | Température (°C) |
|---|---|
| 0 | +20 |
| 60 | -40 |
| 150 | -40 |
| 210 | 20 |
| 300 | +105 |
| 420 | -105 |
| 480 | +20 |

Durant ces cycles, l'humidité dans la chambre de mesure n'est pas contrôlée. L'échantillon subit au moins 60 cycles successifs. Une tension de 14V (+/ - 0,2) est appliquée sur l'échantillon pendant les phases de montée en température (norme VW80101).

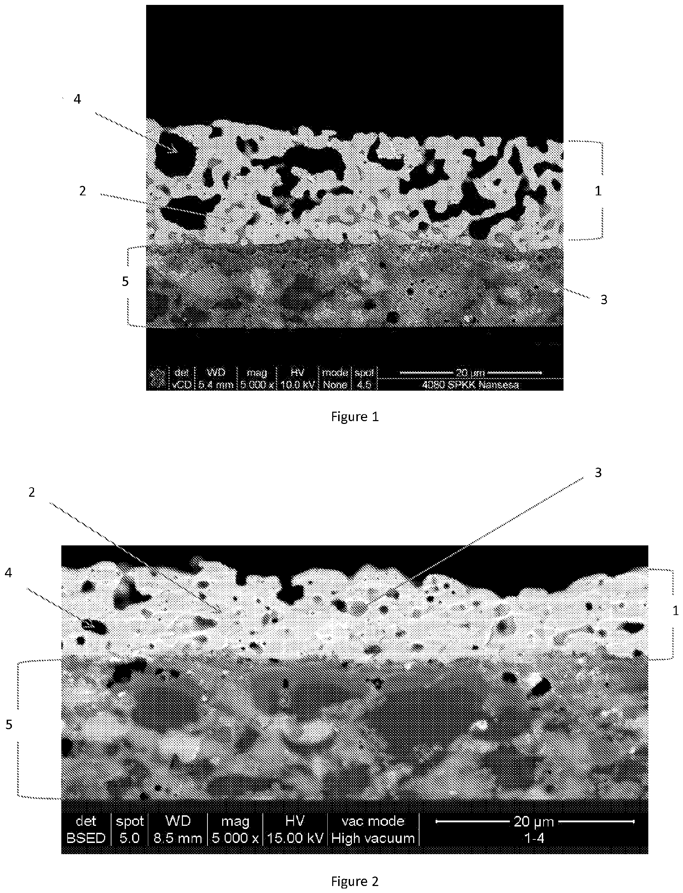

La figure 1 est une image observée par microscopie électronique à balayage d'un échantillon non conforme à l'invention sur laquelle on observe un niveau de porosité élevé (supérieur à 20%) de la couche électroconductrice (1).

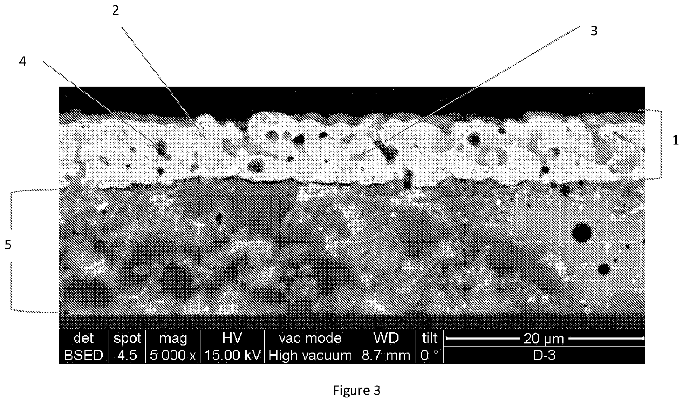

Les figure 2 et 3 sont des images observées par microscopie électronique à balayage d'un échantillon conforme à l'invention sur lesquelles on observe un niveau de porosité faible (inférieur à 20%) de la couche électroconductrice (1).

Sur ces photos, les zones en gris clair (2) correspondent à la couche électroconductrice en argent (1), les zones en gris plus foncé (3) à la fritte de verre et les zones noires (4) à la porosité de la couche d'argent.

Sur ces figures, la couche électroconductrice (1) est déposée sur une couche d'émail (5).

Dans les exemples ci-après, les mesures de granulométrie ont été réalisées avec un granulomètre laser Mastersizer MS2000, fonctionnant avec une source de lumière rouge de type laser He-Ne et une source de lumière bleue de type LED, après dispersion de la pâte d'argent dans de l'acétone. Pour préparer les échantillons, 50 mg de pâte d'argent sont dilués dans 20 mL d'acétone.

Les mesures de la taille des pores, et notamment la mesure de leur plus grande longueur est effectuée à partir des images observées en microscopie à balayage après cuisson de la piste électroconductrice.

Exemple 1 comparatif (non conforme à l'invention)

Plusieurs échantillons sont fabriqués en déposant une couche de pâte conductrice en argent sur une zone d'un substrat en verre sur laquelle a été déposée une couche d'émail noir. Les particules d'argent de cette pâte se présentent essentiellement sous la forme de flocons dont la taille est comprise entre 0,5 et 10 μm. La granulométrie des particules d'argent est telle que le diamètre moyen D10 est de 1,25 μm. La couche de pâte d'argent et la couche d'émail sont déposées par sérigraphie, avec un écran constitué d'un tissu de fils de polyesters assemblés en un maillage de 77.55 mesh. La pâte en argent est séchée à 150°C puis est frittée sous air à une température de 640 °C, pendant une durée de 140 secondes puis le substrat ainsi revêtu est trempé. L'échantillon ainsi obtenu est découpé et placé dans un polisseur ionique afin que sa coupe transversale soit polie. Le polissage est effectué avec une polisseuse de type Hitatchi IM4000 fonctionnant sous un débit d'argon, avec une tension de 6kV, pendant un cycle de polissage de 2 heures. L'observation est ensuite réalisée au microscope électronique à balayage par détection des électrons rétrodiffusés, avec un grossissement de 5000, sous une tension de 10 kV. L'observation est réalisée sur une zone de 50 μm de long. Le niveau de porosité est évalué en mesurant le pourcentage de zones noires sur l'échantillon étudié. Par analyse de l'image obtenue avec le logiciel Image Pro. La piste électroconductrice ainsi obtenue présente un niveau de porosité mesuré par microscopie électronique à balayage d'environ 30% La plus grande longueur des pores L90 vaut 8,5 μm.

La mesure de résistivité est effectuée en utilisant un profilomètre de surface de la marque Taylor Hobson Talysurf 50 pour déterminer la section d'une longueur de 1 m de fil. La résistivité de la piste électroconductrice est de 4.5 μΩ.cm, à 25°C.

Un connecteur en acier inoxydable (référencé sous le numéro 1.4016) est soudé par induction par l'intermédiaire d'un alliage Sn96.5Ag3Cu0.5 sur la piste électroconductrice en argent. Préalablement à cette étape de soudure, le substrat en verre avait été préchauffé à 60°C et la piste électroconductrice avait subi un brossage de surface avec une brosse en laine d'acier.

Le substrat en verre sur lequel est soudé le connecteur électrique est ensuite soumis 60 fois consécutives au cycle de température décrit ci-avant.

A l'issu de ces tests, on observe dans tous les échantillons préparés d'importantes fissures. De tels échantillons ne passent donc pas les critères imposés par le test de variation de température.

Exemple 2 selon l'invention

Des échantillons ont été préparés selon le même mode opératoire que celui décrit dans l'exemple 1, avec une pâte d'argent conductrice différente. L'émail utilisé est identique à celui de l'exemple 1. Les particules d'argent de cette pâte se présentent essentiellement sous la forme de flocons dont la taille est comprise entre 1 et 6 μm et de particules sphériques de taille comprise entre 140 et 400 nm. La granulométrie des particules d'argent est telle que le diamètre moyen D10 est de 0,46 μm. La piste électroconductrice obtenue à partir de cette pâte d'argent a un niveau de porosité de 16% et une résistivité de 3.2 μΩ.cm, à 25°C. La plus grande longueur des pores L90 vaut 3,5 μm. L'alliage de soudure et les connecteurs utilisés sont également identiques à ceux de l'exemple 1. Deux types de soudure (soudures par induction et soudures résistives) ont été testés sur différents échantillons. Les échantillons ont ensuite été soumis aux tests cycliques de variation de température, dans les mêmes conditions que celles décrites dans l'exemple 1.

Tous les échantillons ont passé le test avec succès, sans que des fissures n'apparaissent.

Exemple 3 selon l'invention

Des échantillons ont été préparés selon le même mode opératoire que celui décrit dans l'exemple 1, avec une pâte d'argent conductrice différente de celle des exemples 1 et 2. L'émail utilisé est identique à celui de l'exemple 1. Les particules d'argent de cette pâte se présentent essentiellement sous la forme de sphères dont la taille est comprise entre 1,2 et 2,4 μm et de plus petites particules de taille comprises entre 70 et 400 nm. La granulométrie des particules d'argent est telle que le diamètre moyen D10 est de 0,43 μm. La piste électroconductrice obtenue à partir de cette pâte d'argent a un niveau de porosité de 15% et une résistivité de 2.8 μΩ.cm, à 25°C. La plus grande longueur des pores L90 vaut 1,8 μm. L'alliage de soudure et les connecteurs utilisés sont également identiques à ceux de l'exemple 1. Deux types de soudure (soudures par induction et soudures résistives) ont été testés sur différents échantillons. Les échantillons ont ensuite été soumis aux tests cycliques de variation de température, dans les mêmes conditions que celles décrites dans l'exemple 1.

Tous les échantillons ont passé le test avec succès, sans que des fissures n'apparaissent.

Exemple 4 selon l'invention

Des échantillons identiques à ceux décrits dans l'exemple 2 ont été préparés en utilisant un autre émail noir que celui utilisé dans l'exemple 2. Les autres composants du système sont tous identiques à ceux décrits dans l'exemple 2. Tous les échantillons ainsi obtenus ont passé le test avec succès, sans que des fissures n'apparaissent.

**Revendications**

**1.** Vitrage constitué d'un substrat dont au moins une partie comprend un élément conducteur électrique, ledit élément conducteur comprenant un connecteur en acier contenant du chrome, soudé par un alliage de soudure à base d'étain, d'argent et de cuivre sur une piste électroconductrice, dans lequel la piste électroconductrice à base d'argent a une résistivité mesurée à 25°C inférieure ou égale à 3.5 μΩ.cm et un niveau de porosité inférieur à 20%, ledit niveau de porosité étant mesuré par microscopie électronique à balayage sur une coupe transversale de la partie du substrat comprenant la piste électroconductrice et ayant été préalablement polie par polissage ionique.

2.  Vitrage selon la revendication précédente **caractérisée en ce que** la piste électroconductrice est une pâte d'argent frittée comprenant un mélange de poudre d'argent et de fritte de verre.

3.  Vitrage selon l'une des revendications précédentes **caractérisé en ce que** la piste électroconductrice à base de pâte d'argent a une distribution de porosité pour laquelle la plus grande longueur de 90% des pores est inférieure à 6 μm.

4.  Vitrage selon l'une des revendications précédentes **caractérisé en ce que** la pâte d'argent comprend des particules de tailles différentes parmi lesquelles on trouve des petites particules de taille inférieure à 500 nm.

5.  Vitrage selon la revendication 4 **caractérisé en ce que** les petites particules sont de forme sphérique dont le diamètre est inférieur à 500nm

6.  Vitrage selon l'une des revendications précédentes **caractérisé en ce que** la granulométrie des particules d'argent présentes dans la piste élecroconductrice est telle que le diamètre moyen D10 est inférieur à 1,1 μm, le diamètre D10 représentant le diamètre pour lequel 10% des particules ont un diamètre inférieur à cette valeur.

7.  Vitrage selon l'une des revendications précédentes **caractérisé en ce que** l'alliage de soudure est un alliage comprenant de 90 à 99,5% en poids d'étain, préférentiellement de 93 à 99% en poids et encore plus préférentiellement de 95 à 98% en poids d'étain.

8.  Vitrage selon la revendication 7 **caractérisé en ce que** l'alliage de soudure comprend également, en plus de l'étain de 0,5 à 5 % en poids d'argent et jusqu'à 5% en poids de cuivre.

9.  Vitrage selon l'une des revendications précédentes **caractérisé en ce que** l'alliage de soudure est un alliage contenant 96,5% en poids d'étain, 3% en poids d'argent et 0,5% en poids de cuivre.

10. Vitrage selon l'une des revendications précédentes **caractérisé en ce que** le connecteur électrique est en acier inoxydable.

11. Vitrage selon l'une des revendications précédentes **caractérisé en ce que** le connecteur électrique possède sur sa face inférieure destinée à être placée sur le substrat au moins deux plots ou un espaceur.

12. Vitrage selon l'une des revendications précédentes **caractérisé en ce que** l'épaisseur de la piste électroconductrice en argent mesurée après frittage varie entre 2 et 30 μm et préférentiellement entre 5 et 15 μm.

13. Vitrage selon l'une des revendications précédentes, **caractérisé en ce que** le substrat est un verre trempé.

14. Vitrage selon l'une des revendications 1 à 12 **caractérisé en ce que** le substrat est un verre non trempé.

15. Procédé de fabrication d'un vitrage constitué d'au moins un substrat possédant un système de connexion électrique, ledit procédé comprenant les étapes suivantes :

    - application d'un alliage de soudure à base d'étain, de cuivre et d'argent sur au moins une zone de contact d'un connecteur électrique en acier à base de chrome,
    - placement du connecteur électrique muni de l'alliage de soudure sur une piste électroconductrice en argent déposée sur le substrat nu ou avec un revêtement, ladite piste ayant une résistivité mesurée à 25°C inférieure ou égale à 3.5 μΩ.cm et un niveau de porosité inférieur à 20% ledit niveau de porosité étant mesuré par microscopie électronique à balayage sur une coupe transversale de la partie du substrat comprenant la piste électroconductrice, préalablement polie par polissage ionique et
    - soudure de la zone de contact du connecteur à la piste électroconductrice en argent.

16. Procédé selon la revendication précédente **caractérisé en ce que** pendant l'étape a) une plaquette ou une goutte aplatie d'une épaisseur inférieure ou égale à 0,6 mm est déposée sur la zone de contact du connecteur.

17. Procédé selon l'une des revendications 15 ou 16 **caractérisé en ce que** la soudure du connecteur sur la piste électroconductrice en argent est réalisée par poinçonnage, par soudage par piston, par soudage par microflamme, par soudage laser, par soudage sous air chaud, par soudage par induction, par soudage résistif, par soudage au fer et/ou avec des ultrasons.

18. Utilisation d'un vitrage selon l'une des revendications 1 à 14 dans des bâtiments ou véhicules, en particulier des véhicules automobiles, des véhicules ferroviaires ou des avions

19. Utilisation selon la revendication 18 en tant que pare-brise, fenêtres latérales, lunettes arrière ou toit chauffants ou équipés d'une antenne ou de tout autre fonction électrique disposée sur ou dans le vitrage.

**Patentansprüche**

1. Verglasung, bestehend aus einem Substrat, von dem mindestens ein Teil ein elektrisch leitendes Element umfasst, wobei das leitende Element einen Verbinder aus chromhaltigem Stahl umfasst, der durch eine Lötlegierung auf Zinn-, Silber- und Kupferbasis auf eine elektrische Leiterbahn gelötet ist, wobei die elektrische Leiterbahn auf Silberbasis einen bei 25 °C gemessenen Widerstand von 3,5 $\mu\Omega$.cm oder weniger und ein Porositätsniveau von weniger als 20 % aufweist, wobei das Porositätsniveau durch Rasterelektronenmikroskopie an einem Querschnitt des Teils des Substrats gemessen wird, der die elektrische Leiterbahn umfasst und zuvor durch ionisches Polieren poliert worden ist.

2. Verglasung nach dem vorstehenden Anspruch, **dadurch gekennzeichnet, dass** die elektrische Leiterbahn eine gesinterte Silberpaste ist, die eine Mischung aus Silberpulver und Glasfritte umfasst.

3. Verglasung nach einem der vorstehenden Ansprüche, **dadurch gekennzeichnet, dass** die elektrische Leiterbahn auf der Basis von Silberpaste eine Porositätsverteilung aufweist, bei der die maximale Länge von 90 % der Poren weniger als 6 $\mu$m beträgt.

4. Verglasung nach einem der vorstehenden Ansprüche, **dadurch gekennzeichnet, dass** die Silberpaste Partikel unterschiedlicher Größe umfasst, unter denen sich kleine Partikel mit einer Größe von weniger als 500 nm befinden.

5. Verglasung nach Anspruch 4, **dadurch gekennzeichnet, dass** die kleinen Partikel kugelförmig sind und einen Durchmesser von weniger als 500 nm aufweisen

6. Verglasung nach einem der vorstehenden Ansprüche, **dadurch gekennzeichnet, dass** die Korngröße der in der elektrischen Leiterbahn vorhandenen Silberpartikel so ist, dass der mittlere Durchmesser D10 kleiner als 1,1 $\mu$m beträgt, wobei der Durchmesser D10 den Durchmesser darstellt, bei dem 10 % der Partikel einen Durchmesser unterhalb dieses Wertes aufweisen.

7. Verglasung nach einem der vorstehenden Ansprüche, **dadurch gekennzeichnet, dass** die Lötlegierung eine Legierung ist, die 90 bis 99,5 Gew.-% Zinn, vorzugsweise 93 bis 99 Gew.-% und noch mehr bevorzugt 95 bis 98 Gew.-% Zinn umfasst.

8. Verglasung nach Anspruch 7, **dadurch gekennzeichnet, dass** die Lötlegierung zusätzlich zu dem Zinn auch 0,5 bis 5 Gew.-% Silber und bis zu 5 Gew.-% Kupfer umfasst.

9. Verglasung nach einem der vorstehenden Ansprüche, **dadurch gekennzeichnet, dass** die Lötlegierung eine Legierung ist, die 96,5 Gew.-% Zinn, 3 Gew.-% Silber und 0,5 Gew.-% Kupfer enthält.

10. Verglasung nach einem der vorstehenden Ansprüche, **dadurch gekennzeichnet, dass** der elektrische Verbinder aus rostfreiem Stahl besteht.

11. Verglasung nach einem der vorstehenden Ansprüche, **dadurch gekennzeichnet, dass** der elektrische Verbinder auf seiner Unterseite, die auf dem Substrat platziert werden soll, mindestens zwei Kontaktstellen oder einen Abstandshalter aufweist.

12. Verglasung nach einem der vorstehenden Ansprüche, **dadurch gekennzeichnet, dass** die nach dem Sintern gemessene Dicke der elektrischen Leiterbahn aus Silber zwischen 2 und 30 $\mu$m und vorzugsweise zwischen 5 und 15 $\mu$m variiert.

13. Verglasung nach einem der vorstehenden Ansprüche, **dadurch gekennzeichnet, dass** das Substrat ein gehärtetes Glas ist.

14. Verglasung nach einem der Ansprüche 1 bis 12, **dadurch gekennzeichnet, dass** das Substrat ein nicht gehärtetes Glas ist.

15. Verfahren zum Herstellen einer Verglasung, die aus mindestens einem Substrat besteht, das ein elektrisches Verbindungssystem besitzt, wobei das Verfahren die folgenden Schritte umfasst:

   - Aufbringen einer Lötlegierung auf Zinn-, Kupfer- und Silberbasis auf mindestens einen Kontaktbereich eines elektrischen Verbinders aus chrombasiertem Stahl,
   - Platzieren des mit der Lötlegierung versehenen elektrischen Verbinders auf einer elektrischen Leiterbahn aus Silber, die auf dem blanken oder beschichteten Substrat aufgebracht ist, wobei die Bahn einen bei 25 °C gemessenen Widerstand von 3,5 μΩ.cm oder weniger und ein Porositätsniveau von weniger als 20 % aufweist, wobei das Porositätsniveau durch Rasterelektronenmikroskopie an einem Querschnitt des Teils des Substrats gemessen wird, der die elektrische Leiterbahn umfasst, der zuvor durch ionisches Polieren poliert worden ist, und
- Löten des Kontaktbereichs des Verbinders an die elektrische Leiterbahn aus Silber.

16. Verfahren nach dem vorstehenden Anspruch, **dadurch gekennzeichnet, dass** während Schritt a) ein Plättchen oder ein abgeflachter Tropfen mit einer Dicke von 0,6 mm oder weniger auf den Kontaktbereich des Verbinders aufgebracht wird.

17. Verfahren nach einem der Ansprüche 15 oder 16, **dadurch gekennzeichnet, dass** das Löten des Verbinders auf die elektrische Leiterbahn aus Silber durch Stanzen, durch Kolbenlöten, durch Mikroflammenlöten, durch Laserlöten, durch Heißluftlöten, durch Induktionslöten, durch Widerstandslöten, durch Löten mit Eisen und/oder mit Ultraschall durchgeführt wird.

18. Verwendung einer Verglasung nach einem der Ansprüche 1 bis 14 in Gebäuden oder Fahrzeugen, insbesondere in Kraftfahrzeugen, Schienenfahrzeugen oder Flugzeugen

19. Verwendung nach Anspruch 18 als Windschutzscheibe, Seitenfenster, Heck- oder Dachscheiben, die beheizbar sind oder mit einer Antenne oder einer beliebigen anderen elektrischen Funktion ausgestattet sind, die auf oder in der Verglasung angeordnet ist.

**Claims**

1. Glazing consisting of a substrate at least one portion of which comprises an electrically conductive element, said conductive element comprising a connector made of chromium-containing steel, which connector is soldered with a solder based on tin, silver and copper to an electrically conductive track, wherein the electrically conductive track, which is silver-based, has a resistivity measured at 25°C lower than or equal to 3.5 μΩ.cm and a porosity level lower than 20%, said porosity level being measured by scanning electron microscopy from a cross section through the portion of the substrate comprising the electrically conductive track and having been polished beforehand by ion milling.

2. Glazing according to the preceding claim, **characterized in that** the electrically conductive track is a fritted silver paste comprising a mixture of silver powder and glass frit.

3. Glazing according to one of the preceding claims, **characterized in that** the silver-based electrically conductive track has a porosity distribution such that the longest length of 90% of the pores is lower than 6 μm.

4. Glazing according to one of the preceding claims, **characterized in that** the silver paste comprises some particles with different sizes, among which small particles with a size less than 500 nm are present.

5. Glazing according to claim 4, **characterized in that** the small particles have a spherical form whose diameter is less than 500 nm.

6. Glazing according to one of the preceding claims **characterized in that** the granulometry of the silver particles present in the electrically conductive paste is such that the average diameter D10 is less than 1.1 μm, the diameter D10 representing the diameter for which 10% of the particles have a diameter below that value.

7. Glazing according to one of the preceding claims, **characterized in that** the solder alloy is an alloy comprising from 90 to 99.5% by weight tin, preferably from 93 to 99% by weight tin and even more preferably from 95 to 98% by weight tin.

8. Glazing according to Claim 7, **characterized in that** the solder alloy also comprises, in addition to the tin, 0.5 to 5% by weight silver and up to 5% by weight copper.

9. Glazing according to one of the preceding claims, **characterized in that** the solder alloy is an alloy comprising 96.5% by weight tin, 3% by weight silver and 0.5% by weight copper.

10. Glazing according to one of the preceding claims, **characterized in that** the electrical connector is made of stainless steel.

11. Glazing according to one of the preceding claims, **characterized in that** the electrical connector possesses on its lower face, which is intended to be placed on the substrate, at least two dimples or a spacer.

12. Glazing according to one of the preceding claims, **characterized in that** the thickness of the silver electrically conductive track measured after fritting varies between 2 and 30 μm and preferably between 5 and 15 μm.

**13.** Glazing according to one of the preceding claims, **characterized in that** the substrate is a tempered glass.

**14.** Glazing according to one of claims 1 to 12, **characterized in that** the substrate is a non tempered glass.

**15.** Process for manufacturing a glazing consisting of at least one substrate possessing an electrically connecting system, said process comprising the following steps:

- applying a solder alloy based on tin, copper and silver to at least one contact zone of an electrical connector made of a chromiumbased steel;
- placing the electrical connector equipped with the soldering alloy on a silver electrically conductive track deposited on the either coated or uncoated substrate, said track having a resistivity measured at 25°C lower than or equal to 3.5 $\mu\Omega$.cm and a porosity level lower than 20%, said porosity level being measured by scanning electron microscopy from a cross section through the portion of the substrate comprising the electrically conductive track, which is polished beforehand by ion milling; and
- soldering the contact zone of the connector to the electrically conductive silver track.

**16.** Process according to the preceding claim, **characterized in that** in step a) a pad or flattened droplet of a thickness smaller than or equal to 0.6 mm is deposited on the contact zone of the connector.

**17.** Process according to either of Claims 15 and 16, **characterized in that** the connector is soldered to the electrically conductive silver track by stamping, piston soldering, micro-flame soldering, laser soldering, hotair soldering, induction soldering, resistive soldering, with a soldering iron and/or ultrasonically.

**18.** Use of a glazing according to one of Claims 1 to 14 in buildings or vehicles and in particular automotive vehicles, rail vehicles or aeroplanes.

**19.** Use according to Claim 18 as heated windscreens, side windows, rear windscreens or roofs or windscreens, side windows, rear windscreens or roofs equipped with an antenna or with any other electrical function placed on or in the glazing.

Figure 1

Figure 2

Figure 3

**EP 3 386 747 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2015162677 A1
- US 20140110166 A